# FASCICULE DE BREVET EUROPEEN

(11) **EP 3 396 705 B1**
(45) Date de publication et mention de la délivrance du brevet: **16.12.2020**
(21) Numéro de dépôt: 18168512.4
(22) Date de dépôt: 20.04.2018
(51) Int. Cl.: H01L 21/50, H01L 23/10

(54) **CELLULE DE SCELLEMENT ET PROCEDE D'ENCAPSULATION D'UN COMPOSANT MICROELECTRONIQUE AVEC UNE TELLE CELLULE DE SCELLEMENT**
VERSIEGELUNGSVORRICHTUNG UND VERKAPSELUNGSVERFAHREN FÜR EINE MIKROELEKTRONISCHE KOMPONENTE MIT EINER SOLCHEN VERSIEGELUNGSVORRICHTUNG
SEALING APPARATUS AND METHOD FOR ENCAPSULATING A MICROELECTRONIC COMPONENT WITH SUCH A SEALING APPARATUS

(30) Priorité: 25.04.2017 FR 1753597
(43) Date de publication de la demande: 31.10.2018
(73) Titulaire: Commissariat à l'énergie atomique et aux énergies alternatives, 75015 Paris (FR)
(72) Inventeur: BEDJAOUI, Messaoud, 38340 VOREPPE (FR); BRUN, Jean, 38800 CHAMPAGNIER (FR); AMIRAN, Johnny, 38690 EYDOCHE (FR)
(74) Mandataire: Brevalex

(56) Documents cités:
- US-A1- 2003 027 371
- US-A1- 2003 111 441
- US-A1- 2006 197 215
- US-A1- 2008 164 606
- US-A1- 2014 111 919
- US-A1- 2016 035 592
- US-B2- 8 878 051

## Description

### DOMAINE TECHNIQUE ET ÉTAT DE LA TECHNIQUE ANTÉRIEURE

La présente invention se rapporte à une cellule de scellement pour encapsuler des composants microélectroniques pour les protéger d'une atmosphère extérieure, et notamment de l'air, et plus particulièrement à une cellule de scellement pour encapsuler des composants microélectroniques sensibles à l'air.

La présente invention concerne également un procédé d'encapsulation mettant en œuvre la cellule de scellement.

Les composants microélectroniques (de dimensions nanométriques ou micrométriques), et plus particulièrement, les dispositifs électrochimiques tels que les microbatteries tout solides en couches minces sont, depuis quelques années, devenus incontournables dans le développement des systèmes intelligents embarqués. Dans le cas particulier des microbatteries au lithium, l'utilisation des matériaux lithiés en couches minces est très critique en raison de leur très forte sensibilité aux éléments atmosphériques tels que l'oxygène et la vapeur d'eau. Ces batteries nécessitent donc d'être encapsulées pour garantir leur intégrité électrochimique mais aussi mécanique dans le temps.

Plusieurs procédés existent pour encapsuler des composants microélectroniques. Néanmoins, la température de fusion du lithium (environ 180°C) ainsi que la taille des composants restreignent le choix des possibilités. Par exemple, les procédés d'encapsulation de composants par laminage ne sont pas adaptés aux microbatteries à haute densité (augmentation de la surface active par rapport à la surface du packaging).

L'une des technologies porteuses pour l'encapsulation des microbatteries fait appel aux techniques de report de capots fins (épaisseur de 100µm à 500µm), ou ultrafins (épaisseur inférieure à 100µm), sur des substrats hôtes contenant les composants à encapsuler. L'intégration de ces capots est réalisée à l'aide de cordons de scellement, disposés autour des microbatteries, et qui sont scellés à la fois au substrat et au capot.

Il est, par exemple, possible de sceller un capot sur un substrat hôte par thermocompression. Cette technique consiste à exercer une pression homogène entre le substrat et le capot et de chauffer tout le substrat pour faire fondre les cordons de scellement et les vitrifier. Cependant, ce procédé est inapplicable dans le cas des composants microélectroniques sensibles à la température car la température de chauffage peut atteindre quelques centaines de degrés en fonction de la pâte utilisée.

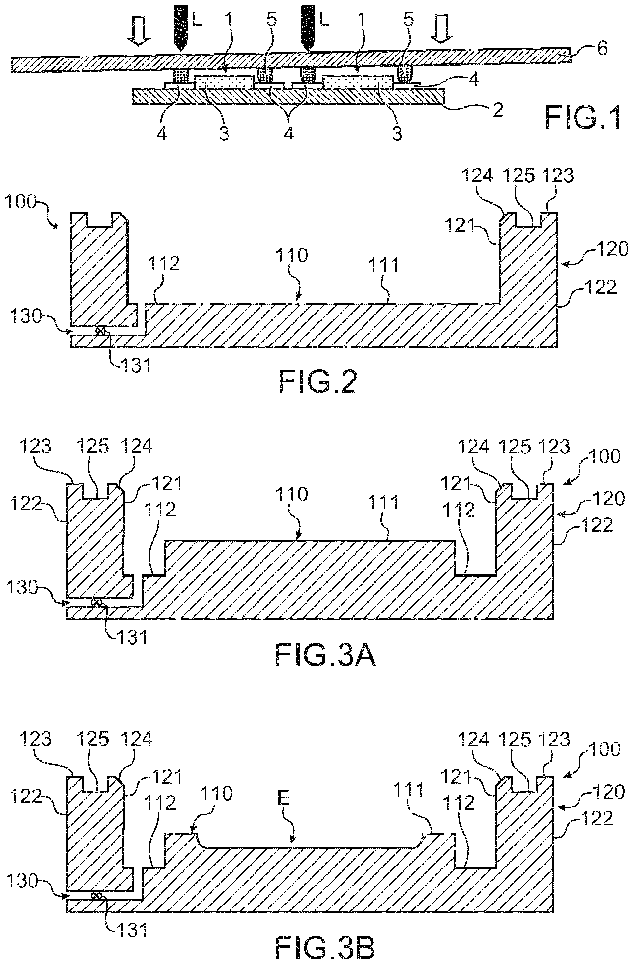

Une des techniques les plus prometteuses est l'encapsulation par scellement laser : les cordons de scellement sont chauffés localement par irradiation, ce qui limite les risques de dégradation des couches lithiées. Cette technique est, particulièrement, adaptée pour des dispositifs de faibles dimensions. Classiquement, comme représenté sur la figure 1, le procédé consiste à former une microbatterie 1 sur un substrat, en verre. La microbatterie comprend un empilement de couches actives 3 et des collecteurs de courant 4. Les cordons de scellement 5, en pâte de verre, sont formés sur la face du capot 6 destinée à être en regard de la microbatterie. Le capot 6 est reporté sur le substrat 2, les cordons de scellement 4 étant positionnés au niveau des collecteurs de courant 4 de la microbatterie 1. Chaque microbatterie 1 est entourée par un cordon pour assurer l'étanchéité latérale. Une force mécanique (représentées par les flèches F sur la figure 1) est appliquée verticalement sur toute la surface du capot 6 pour réduire l'espace entre le capot 6 et le substrat 2, et assurer que le cordon 5 soit en contact à la fois avec le capot 6 et le substrat 2. Une fois que le capot 6 et le substrat 2 sont positionnés, les cordons 5 sont chauffés par irradiation laser pour être vitrifiés. Dans les documents US2011/0241060A1 et WO2006/045067A1, ce procédé d'encapsulation est utilisé, par exemple, pour encapsuler des composants microélectroniques, comme des diodes électroluminescentes organiques (OLED pour « Organic Light Emitting Diode »).

Cependant, des défauts de planéité peuvent se produire lorsque le cordon 5 fond localement sous l'effet de l'irradiation. Comme représenté sur la figure 1, lors du procédé d'encapsulation, le cordon 5 en pâte de verre fond au fur et à mesure du passage du faisceau laser (représentées par les flèches L). La partie du cordon qui a fondu présente une épaisseur inférieure à celle de la partie non fondue, ce qui génère un défaut de planéité. L'espace entre le capot 6 et le substrat hôte 2 augmente localement, conduisant à un décollement d'une partie du cordon 5 soit du substrat 2 soit du capot 6. Or, une soudure étanche et robuste nécessite une mise en contact parfaite. L'application de la force mécanique sur l'ensemble du capot 6 ne permet pas de compenser ce défaut de planéité. Ce phénomène est prépondérant pour des capots 6 ayant de grandes surfaces, réduisant ainsi le bénéfice industriel et technologique de ce procédé d'encapsulation.

US 8 878 051 B2 divulgue une cellule de scellement ainsi qu'un procédé correspondant sous forme d'une presse comprenant un système de pompage.

US 2016/035592 A1 divulgue une cellule de scellement ainsi qu'un procédé correspondant, comprenant un capot dans un matériau élastique afin d'exercer une force grâce au vide sur une couche de scellement.

US 2014/111919 A1 divulgue une cellule de scellement ainsi qu'un procédé correspondant sous forme d'une presse comprenant un système de pompage.

### EXPOSÉ DE L'INVENTION

C'est, par conséquent, un but de la présente invention de proposer un dispositif permettant d'encapsuler efficacement des composants microélectroniques.

C'est également un but de la présente invention de proposer un procédé d'encapsulation remédiant aux inconvénients de l'art antérieur et, en particulier, de proposer un procédé d'encapsulation de composants microélectroniques sensibles à l'air et/ou aux températures élevées (supérieures ou égales à 180°C) permettant de former des soudures étanches et solides mécaniquement.

Ces buts sont atteints par une cellule de scellement selon la revendication 11 pour encapsuler un composant microélectronique, disposé sur un substrat, avec un capot, ladite cellule de scellement comprenant :
- un fond comprenant une zone d'accueil pour le substrat et une zone périphérique entourant la zone d'accueil,
- une paroi latérale formée d'une face interne, d'une face externe et d'une face supérieure, la face supérieure étant configurée pour supporter le capot en regard de la zone d'accueil,
- une ouverture, disposée dans le fond de la cellule, dans la paroi latérale, ou dans le capot, l'ouverture étant configurée pour être reliée à un système de pompage, de manière à pouvoir mettre sous atmosphère contrôlée une cavité délimitée par la paroi latérale, le fond et le capot.

L'invention propose un dispositif d'encapsulation pouvant être mis sous atmosphère contrôlée, et notamment sous vide, et compatible avec les procédés de scellement laser des substrats/capots fins et ultrafins. Par mise sous vide, on entend que le dispositif est amené à une pression inférieure à la pression ambiante qui d'environ de 1013,25hPa.

Le dispositif permet d'encapsuler efficacement les dispositifs microélectroniques disposés sur un substrat avec un capot fin ou ultrafin.

Par fin, on entend une épaisseur de 100µm à 500µm et par ultrafin, on entend une épaisseur inférieure à 100µm.

Avantageusement, la zone d'accueil est surélevée par rapport à la zone périphérique, ce qui permet de déplacer le substrat à encapsuler latéralement, pour le positionner parfaitement par rapport au capot.

Avantageusement, la paroi latérale dépasse de la zone d'accueil d'une épaisseur supérieure à l'épaisseur du substrat avec le composant microélectronique, par exemple d'au moins 50µm, et de préférence d'au moins 100µm. La paroi latérale dépasse, vers le haut, de la zone d'accueil afin de pouvoir maximiser, lors de la mise sous vide de la cellule de scellement la force d'appui sur le cordon de scellement qui entoure le composant microélectronique à encapsuler.

Avantageusement, un chanfrein est disposé entre la face supérieure et la face interne de la paroi latérale. Ceci facilitera la déformation du capot lors de la mise sous vide de la cellule de scellement, évitant la création de contraintes mécaniques, et la fragilisation du capot, surtout pour un capot de faible épaisseur, qu'il y aurait avec une arête saillante.

Avantageusement, la face supérieure de la paroi latérale présente une rainure, dans laquelle est inséré un joint. L'étanchéité de la cellule de scellement est ainsi améliorée.

Avantageusement, la paroi latérale est circulaire, pour mieux répartir les contraintes mécaniques sur le capot lors de la mise sous vide. L'homme du métier peut choisir toute autre géométrie de paroi à condition d'être adaptée à la forme du capot.

Avantageusement, la cellule de scellement est en acier inoxydable, en verre, en céramique, en silicium, en quartz, en cuivre, en aluminium ou en un de leurs mélanges. De tels matériaux présentent des propriétés d'étanchéités suffisantes pour pouvoir mettre en œuvre le procédé.

Avantageusement, la zone d'accueil comprend un évidement, de manière à former un logement pour le substrat. Le substrat sera stabilisé lors du procédé d'encapsulation.

Ce but est également atteint par un procédé d'encapsulation selon la revendication 1 d'un composant microélectronique disposé sur un substrat comprenant au moins les étapes successives suivantes :
a) fourniture d'une cellule de scellement telle que précédemment définie,
b) dépôt d'un cordon de scellement, sur le substrat et/ou sur la face du capot destinée à être en regard du substrat,
c) positionnement du substrat muni du composant microélectronique à encapsuler sur la zone d'accueil de la cellule de scellement, et positionnement du capot sur la face supérieure de la cellule de scellement,
d) mise sous atmosphère contrôlée de la cavité formée par le capot et la cellule de scellement, via l'ouverture, de manière à faire fléchir le capot vers le substrat, jusqu'à mettre en contact le cordon de scellement à la fois avec le substrat et avec le capot,
e) chauffage localisé du cordon de scellement, de manière à sceller le capot au substrat.

Le procédé d'encapsulation de la présente invention exploite les propriétés mécaniques des capots d'encapsulation, avantageusement de faibles épaisseurs, pour s'affranchir des limitations de l'état de l'art antérieur. Ainsi, la flexion du capot de fermeture, sous l'effet de la mise sous vide, ou plus généralement sous atmosphère contrôlée, de l'enceinte proposée, permet une répartition très homogène de la force d'appui au niveau des cordons de scellement, ce qui contribue à l'augmentation de la surface de contact entre les cordons et le substrat/capot par déformation. Cette approche optimise la taille de la zone de scellement en minimisant la surface du cordon de scellement sur le substrat hôte tout en augmentant la surface de contact nécessaire pour la soudure des cordons.

L'augmentation de la température, lors du chauffage localisé, rend les matériaux des cordons plus aisément déformables par effet de fusion, ce qui augmente également la surface de contact.

Avantageusement, le capot présente une épaisseur et un module d'Young lui conférant des propriétés mécaniques lui permettant de fléchir lors de l'étape d), et notamment une épaisseur inférieure ou égale à 500µm et un module d'Young inférieur ou égale à 100 GPa.

Avantageusement, le cordon de scellement est un matériau fusible choisi, notamment, parmi une pâte de verre et un matériau métallique.

Par pâte de verre, on entend un liant organique dans lequel est dispersée une poudre de verre. Par matériau métallique, on entend un métal ou un alliage de métal.

Avantageusement, le cordon de scellement est chauffé par irradiation laser, à travers le capot, le capot étant transparent à la longueur d'onde du laser. L'apport de la chaleur se fait localement grâce au flux thermique résultant du laser sur le cordon de scellement. Seules la zone d'intérêt est chauffée, ce qui préserve le composant microélectronique de la chaleur et évite de le détériorer.

Avantageusement, lors de l'étape d) et/ou de l'étape e), une force mécanique est exercée sur le capot pour accentuer la flexion du capot vers le substrat. La force mécanique complète la force exercée par la déformation du capot, la surface de contact entre le capot et/ou le substrat est augmentée, ce qui conduit à des soudures mécaniquement plus stables.

Avantageusement, la force mécanique est réalisée avec un stylet mécanique. Il est ainsi possible d'appliquer une force de maintien uniquement au niveau de la soudure en cours de réalisation.

Avantageusement, le stylet mécanique est équipé d'une source laser avec, éventuellement, un moyen de focalisation dudit faisceau laser. Le stylet muni de la source laser permet d'avoir un appui ponctuel sur le cordon et de le chauffer localement en focalisant, éventuellement, le faisceau.

Avantageusement, le capot et/ou le substrat, muni du cordon de scellement, est pré-chauffé, avant l'étape c), de manière à dégazer au moins partiellement les produits volatils présents dans le cordon avant scellement. Les produits issus du dégazage ne seront ainsi pas piéger entre le substrat et le capot après encapsulation, et ne pourront pas détériorer les couches actives du composant microélectronique.

Avantageusement, le capot comporte, en outre, un composant microélectronique identique ou différent de celui du substrat. Il est possible de réaliser une intégration 3D.

Avantageusement, les valeurs des coefficients d'expansion thermique du capot, du substrat et du cordon de scellement varient d'au plus 10% entre eux, pour éviter la création de contraintes mécaniques inhomogènes entre les différents éléments de l'assemblage, ce qui pourrait conduire à leurs fragilisations lors du chauffage laser.

Avantageusement, le capot et/ou le substrat et/ou le cordon de scellement sont en verre pour limiter au maximum les contraintes mécaniques lors de l'assemblage. Par en verre, on entend en verre ou à base de verre, c'est-à-dire que ces éléments sont majoritairement formés de verre. Par exemple, ils comprennent plus de 50% massique, de préférence plus de 70% massique de verre.

Avantageusement, le capot et/ou le substrat a une épaisseur inférieure à 100µm. Le procédé permet de reporter des capots de faibles épaisseurs, ce qui est profitable à la miniaturisation. Le procédé tire, en même temps, parti de cette faible épaisseur recherchée, puisque les capots de faible épaisseur seront plus souples et présenteront une plus grande déformation lors de la mise sous vide de la cellule de scellement, augmentant la surface de contact entre les éléments à souder et le cordon de scellement.

Avantageusement, le composant microélectronique est un dispositif électrochimique, notamment une microbatterie solide, par exemple une microbatterie au lithium.

Selon un autre aspect, un mode de réalisation prévoit un dispositif pour la mise en œuvre d'un procédé d'encapsulation tel que défini précédemment.

### BRÈVE DESCRIPTION DES DESSINS

La présente invention sera mieux comprise sur la base de la description qui va suivre et des dessins en annexe sur lesquels :
- la figure 1, déjà commentée, est une représentation schématique d'une étape d'un procédé d'encapsulation de deux microbatteries, disposées sur un substrat, selon l'art antérieur,
- la figure 2 est une représentation schématique, en coupe et de profil, d'une cellule de scellement selon un premier mode de réalisation de l'invention,
- la figure 3A est une représentation schématique, en coupe et de profil, d'une cellule de scellement selon un deuxième mode de réalisation de l'invention,
- la figure 3B est une représentation schématique, en coupe et de profil, d'une cellule de scellement selon un troisième mode de réalisation de l'invention
- la figure 4 est une représentation schématique, en coupe et de profil, d'une microbatterie disposée sur un substrat, selon un mode particulier de réalisation de l'invention,
- les figures 5A à 5G représentent différentes étapes d'un exemple de procédé d'encapsulation de composants microélectroniques, selon l'invention,
- la figure 6 est un graphique montrant la déformation d'un capot lors de la mise sous vide de la cellule de scellement.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et pouvant se combiner entre elles.

### EXPOSÉ DÉTAILLÉ DE MODES DE RÉALISATION PARTICULIERS

### Cellule de scellement :

Sur les figures 2 et 3, on peut voir des représentations schématiques d'une cellule de scellement 100, aussi appelé porte-substrat ou encore cellule de scellement et d'encapsulation, selon différents modes de réalisation de l'invention. La cellule de scellement 100 permet d'encapsuler facilement et efficacement un composant microélectronique sensible à l'air, disposé sur un substrat, avec un capot.

La cellule de scellement 100 comprend un fond 110 composé de deux zones : une zone centrale 111, dite zone d'accueil, sur laquelle sera positionné le substrat, muni du ou des composants à encapsuler, et une zone périphérique 112. La zone périphérique 112 entoure la zone centrale 111. Le fond 110 peut être circulaire, carré, rectangulaire ou de tout autre forme géométrique. De manière avantageuse, le fond 110 est circulaire et la zone périphérique 112 forme un anneau circulaire autour de la zone centrale 111, également circulaire.

Sur la figure 2, le fond 110 est plat : la zone centrale 111 et la zone périphérique 112 sont au même niveau. Selon une variante représentée à la figure 3A, la zone centrale 111 est en surépaisseur par rapport à la zone périphérique 112, c'est-à-dire qu'elle est surélevée par rapport à la zone périphérique 112, qu'elle dépasse de la zone périphérique 112. Ceci, comme nous le verrons par la suite, permet de positionner de manière adéquate le substrat par rapport au capot. La hauteur sera, avantageusement, choisie en fonction de l'épaisseur du substrat, du capot et du composant à encapsuler.

La zone d'accueil 111 peut être évidée localement de manière à former un logement pour le substrat afin d'améliorer sa stabilité durant le procédé d'encapsulation (évidement E sur la figure 3B). Par évider, on entend former un creux, un trou non traversant.

La cellule de scellement 100 comporte également une paroi latérale 120. La paroi latérale 120 est formée d'une face interne 121, d'une face externe 122 et d'une face supérieure 123. La face 121 et la face externe 122 sont, de préférence, parallèles entre elles. La face supérieure 123 est, de préférence, perpendiculaire aux faces interne 121 et externe 122. La face supérieure 123 est configurée pour supporter le capot.

De manière avantageuse, un chanfrein 124 est disposé entre la face supérieure 123 et la face interne 121. Par chanfrein, on entend une petite surface plane formée par une arête abattue. Le chanfrein 124 forme un biseau, pour donner plus de souplesse, comme on le verra plus loin, au capot dans son mouvement de déformation. Comme représenté sur les figures 2 et 3, l'angle α de biseau est inférieur à 90°. De préférence, il va de 10° à 80°, plus préférentiellement de 25° à 65°, et encore plus préférentiellement, il est de l'ordre de 45°.

Avantageusement, la face supérieure 123 présente une rainure 125, ou gorge, configurée pour positionner un joint (non représenté sur les figures 2 et 3). Le joint améliore l'étanchéité entre la cellule de scellement 100 et le capot.

La paroi latérale 120 est, avantageusement, circulaire et le joint est un joint torique, c'est-à-dire sous la forme d'un anneau circulaire de section ronde. On choisira par exemple, un joint avec une dureté standard de 60shore A à 90shore A. Il est, par exemple, fabriqué à partir de matériaux plastiques élastomères comme le butadiène-acrylonitrile (aussi appelé nitrile, également connu sous le nom NBR pour « nitrile butadiene rubber »), les copolymères éthylène propylène ou encore un fluoropolymère tel que le fluorocarbone (ou poly(fluorure de vinylidène) (PVDF)), ou le Viton®. Le choix du joint torique est lié aux dimensions de la gorge (largeur D et profondeur G).

La cellule de scellement 100 comporte également une ouverture 130, disposée dans la zone périphérique 112 (comme représenté sur les figures 2 et 3), pour mettre sous vide la cavité délimitée par la paroi latérale 120, le fond 110 et le capot qui sera positionné sur la paroi latérale 120.

Selon une variante non représentée, l'ouverture 130 peut également être dans la paroi latérale 120.

L'ouverture 130 forme un conduit dans lequel peut être disposé un système de régulation 131, comme par exemple une vanne.

L'ouverture 130 peut être connectée à une pompe, ou à tout système d'aspiration permettant de mettre l'enceinte sous vide.

La cellule de scellement 100 est, avantageusement, un monobloc, c'est-à-dire formé à partir d'une seule pièce, pour améliorer son étanchéité.

Selon une variante, les éléments de la cellule de scellement, et notamment la zone centrale 111 et la zone périphérique 112, peuvent être usinées séparément puis assemblées par fixation ou collage par exemple.

La cellule de scellement 100 est faite d'un matériau pouvant garantir des propriétés d'étanchéité suffisantes à la cellule de scellement vis-à-vis de l'air et de la vapeur d'eau. Le matériau sélectionné aura des vitesses de transmission de la vapeur d'eau (WVTR pour « Water Vapor Transmission Rate ») ou encore en vitesse de transmission de l'oxygène (OTR pour « Oxygen Transmission Rate ») suffisamment faibles pour être considéré comme étanche à la vapeur d'eau et au dioxygène. Par étanche, on entend des valeurs de WVTR d'au plus 10⁻⁴ g.m⁻².j⁻¹ et d'OTR d'au moins 10⁻⁴ cm⁻³.m⁻².j⁻¹.

La cellule de scellement est, par exemple, en acier inoxydable. Cependant, elle pourrait être élaborée à partir d'un autre matériau. A titre illustratif, nous pouvons citer l'aluminium, le cuivre, le silicium, la céramique, le verre, ou encore le quartz. Il peut également s'agir d'un mélange de ces matériaux.

A titre illustratif, les dimensions géométriques de la cellule de scellement sont, par exemple, en se référant aux figures 3A et 3B : R=150mm, R1=25mm, R2=30mm, R3=40mm, H=20mm. De manière avantageuse, la paroi latérale 120 dépasse de la zone d'accueil d'au moins 50µm, et de préférence d'au moins 100µm (hauteur H1 sur les figures 2, 3A et 3B) pour pouvoir positionner le substrat muni du composant microélectronique sur la zone d'accueil. On essaiera en même temps de minimiser cette hauteur H1 pour maximiser la force d'appui sur les cordons de scellement.

La cavité de la cellule de scellement 100 peut être obtenue en évidant un matériau massif par toute technique d'enlèvement de matière. Il peut s'agir d'une méthode thermique (usage de faisceaux d'électrons, par plasma ou laser, par exemple), d'une méthode chimique (dissolution chimique, usinage électrochimique), d'une méthode mécanique (jet liquide avec abrasif, ultrason) ou encore toute technique d'usinage par outils coupants (tournage, fraisage, perçage, alésage, filetage...). A titre illustratif, la cellule de scellement est usinée à partir d'un seul bloc de matériau grâce à une technique de fraisage utilisant des têtes en carbure de tungstène.

De façon générale, l'homme du métier pourra configurer la cellule de scellement selon plusieurs architectures et dimensions à condition qu'elles satisfassent aux fonctionnalités requises (étanchéité, mise sous vide....).

D'un point de vue industriel, la cellule de scellement 100 est un outil facile à utiliser pour réaliser les étapes d'encapsulation, c'est-à-dire de report d'un capot 400 sur un substrat 200.

### Procédé d'encapsulation :

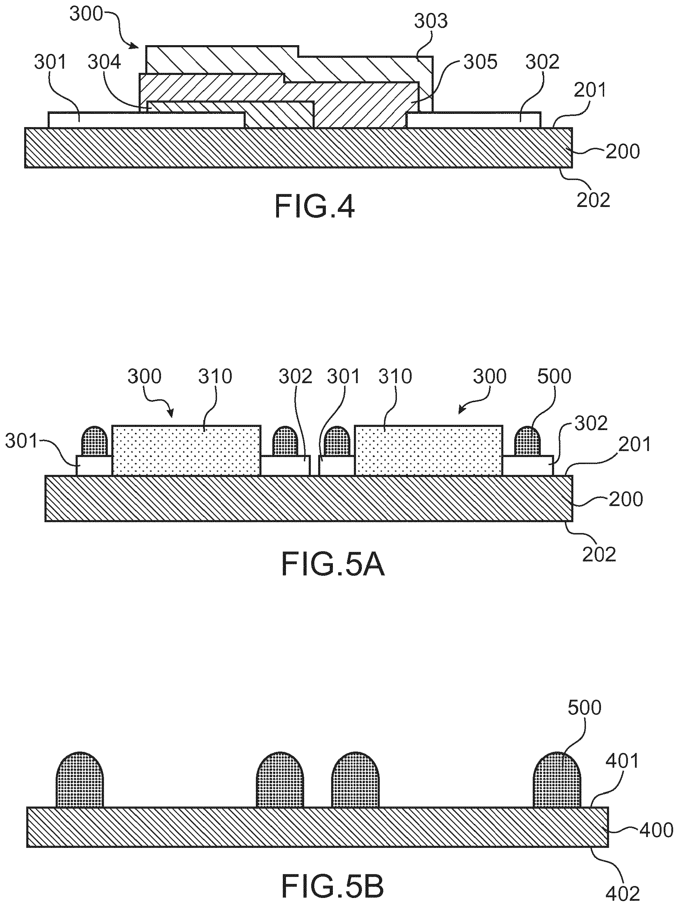

Le procédé d'encapsulation de composants microélectroniques sensibles à l'air (au dioxygène et à la vapeur d'eau), et/ou à des températures élevées (supérieures à 180°C), mettant en œuvre une telle cellule de scellement, va maintenant être décrit en faisant référence aux figures 5A à 5F.

### Composant microélectronique 300 à encapsuler :

Le procédé permet d'encapsuler simultanément un composant ou plusieurs composants microélectroniques disposé sur un substrat ou sur plusieurs substrats. Le substrat est également appelé substrat-hôte. Le composant électronique a une épaisseur allant de 5µm à 30µm, et de préférence de 10 à 15µm. Il peut avoir une surface de quelques centimètres carrés, par exemple il peut avoir une surface d'environ 2,5cmx2,5cm.

Par composant microélectronique, on entend, par exemple, un MEMS (microsystème électromécanique), un MOEMS (microsystème opto-électro-mécanique), ou encore un micro-détecteur infrarouge, ou même un transistor. Plus généralement, par composant microélectronique, on entend tout dispositif destiné à être encapsulé sous atmosphère contrôlée.

Par la suite, même si la description fait référence à une microbatterie, et plus particulièrement à une microbatterie solide, par exemple une microbatterie au lithium, l'invention est transposable à tout composant microélectronique nécessitant une protection vis-à-vis des oxydants et/ou sensible à des températures élevées (supérieures à 180°). Il peut s'agir, par exemple d'un empilement capacitif ou d'un composant électrochimique.

Comme représenté sur la figure 4, le substrat 200 comporte deux faces principales 201, 202. Le composant microélectronique 300, ici la microbatterie, est disposée sur une des faces 201 du substrat 200. La microbatterie comprend des collecteurs de courant cathodique 301 et anodique 302, disposés sur le substrat 200. Deux couches actives, l'une formant l'électrode négative 303, et l'autre formant l'électrode positive 304, sont séparées par une couche d'électrolyte 305. Chaque couche active 303, 304 est en contact avec l'un des collecteurs de courant 301, 302.

Les collecteurs de courant 301, 302 sont, avantageusement, métalliques. A titre illustratif, ils peuvent être en titane, or, aluminium, platine, ou en tungstène.

Le substrat 200 a, avantageusement, les performances requises pour l'encapsulation des microbatteries au lithium. Il est élaboré en un matériau ayant des niveaux de barrière WVTR et OTR au plus, respectivement, de 10⁻⁴ g/m²/j et de 10⁻⁴ cm³/m²/j.

Le substrat 200 est, par exemple, en verre, en céramique, en mica, en silicium, ou encore en quartz. De préférence, il est en verre. Il s'agit par exemple d'un verre de type D263T commercialisé par la société SCHOTT®. Le substrat peut être fin (épaisseur de 100µm à 500µm) ou ultrafin (épaisseur inférieure à 100µm). Le substrat fin a, par exemple, une épaisseur de l'ordre de 50µm.

L'électrode positive 304 (cathode) est en un matériau ayant une bonne conductivité électronique et ionique (par exemple TiOS, TiS₂, LiTiOS, LiTiS₂, LiCoO₂, V₂O₅...). L'électrolyte 305 est un isolant électronique avec une forte conductivité ionique (par exemple LiPON, LiPONB, LiSiCON...). L'électrode négative 303 (anode) est une couche qui peut être du lithium métallique ou un matériau lithié.

La microbatterie sera réalisée par les techniques connues de l'homme du métier.

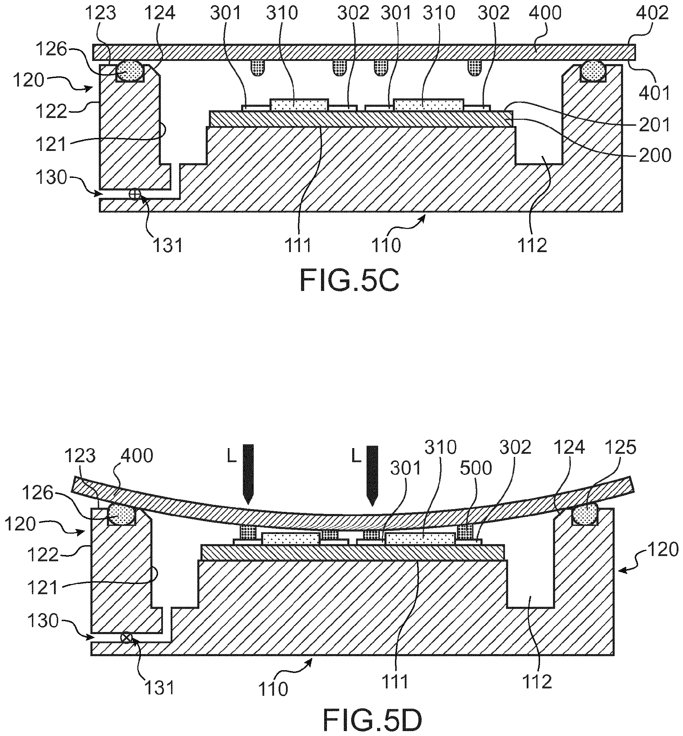

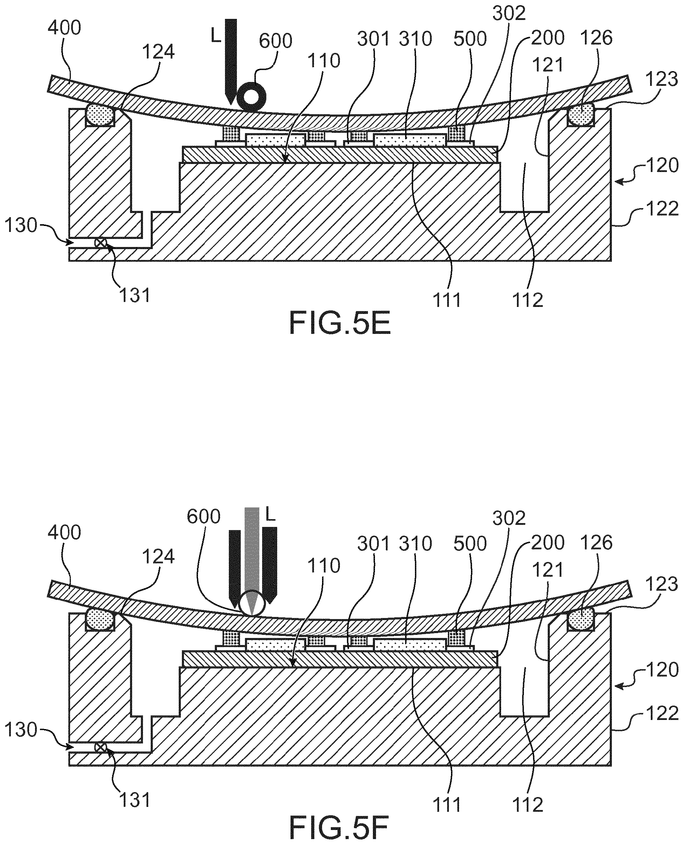

De manière avantageuse, plusieurs microbatteries disposées sur un même substrat sont encapsulées simultanément. Sur la figure 5A et les figures 5B, 5C, 5D, 5E et 5F, seules deux microbatteries 300, sur un même substrat 200, sont représentées pour plus de lisibilité. Pour le procédé, plus de deux batteries pourraient être encapsulées simultanément. Pour faciliter la compréhension des figures, l'ensemble formé par les couches actives et l'électrolyte est représenté sous la forme d'un bloc 310. Les collecteurs de courant 301 et 302 sont également représentés.

### Capot d'encapsulation 400 :

La microbatterie 300 sera encapsulée avec un capot 400, aussi appelé couvercle de scellement ou couvercle d'encapsulation et de scellement. Les formes et les dimensions géométriques ainsi que la nature des matériaux du capot 400 peuvent être différentes de celle du substrat hôte.

Le capot 400 est, avantageusement, transparent à la longueur d'onde du laser. Par transparent, on entend que le capot laisse passer au moins 50% de la lumière émise par le laser de manière à pouvoir chauffer le cordon de scellement à travers le capot 400.

Le capot 400 est étanche vis-à-vis des oxydants de l'air. Le capot 400 a, avantageusement, des niveaux de barrière WVTR et OTR au minimum, respectivement, de 10⁻⁴ g/m²/j et de 10⁻⁴ cm³/m²/j.

Le matériau du capot 400 est également choisi de manière à pouvoir supporter des contraintes de flexion. Il est généralement choisi dans la famille des matériaux présentant des propriétés mécaniques de souplesse autorisant des compressions suffisantes sous l'effet d'une dépression (module d'Young inférieur ou égal à 100GPa). Il a également une faible épaisseur (inférieure ou égale à 500µm) pour pouvoir être fléchi. Le capot peut être également suffisamment rigide pour l'empêcher de rester plié ou fléchi une fois l'assemblage par compression réalisé. Le capot peut être en particulier choisi dans une famille de matériaux présentant un module d'Young supérieur ou égal à 20 GPa.

Le capot 400 considéré a de préférence une faible aptitude au pliage autrement dit une faible ténacité (en anglais « fracture toughness »). Par définition, la ténacité (opposée à la fragilité) est définie comme étant la capacité à résister à la propagation d'une fissure et se mesure en MPa.m^{1/2}. Pour les matériaux du capot 400 (et du substrat 200), la ténacité est généralement inférieure à 20 MPa.m^{1/2} et préférentiellement à 10 MPa.m^{1/2}. Par exemple le verre possède une ténacité de l'ordre de 0.7 MPa.m^{1/2}.

De manière avantageuse, pour éviter d'avoir un matériau qui se dilate plus que les autres sous l'effet de la chaleur, et donc pour éviter d'induire des contraintes mécaniques dans l'assemblage, des matériaux ayant des valeurs de coefficient d'expansion thermique (CTE) les plus proches possibles les uns des autres seront utilisés pour le capot 400 et pour le substrat 200. Par le plus proche possible, on entend que ces valeurs varieront de 0 et 10%.

De manière avantageuse, pour réduire les contraintes mécaniques lors de l'assemblage, des matériaux ayant des valeurs de module d'Young les plus proches possibles les uns des autres seront utilisés pour le capot 400 et pour le substrat 200. Par le plus proche possible, on entend que ces valeurs varieront de 0 et 10%.

De manière préférée, le capot de fermeture et d'encapsulation et le substrat hôte sont choisis parmi les différentes familles de verres (borosilicates ou leurs dérivés, comme le Borofloat® commercialisé par Schott). On peut citer, à titre indicatif et non limitatif, les produits commercialisés par Schott ou Corning sous les références AF45, D263®T, AF32®, Corning®Willow EAGLE XG®, ou encore AS87. Le capot aura, avantageusement, une épaisseur inférieure ou égale à 500µm, et de préférence inférieure à 100µm et un module de Young inférieur ou égal à 100 GPa, et de préférence inférieur à 75 GPa.

Selon une variante, ils pourraient être en silicium ou en céramique, la céramique ayant une ténacité de l'ordre de 7 MPa.m^{1/2}.

Comme représenté sur la figure 5B, le capot 400 comprend deux faces principales 401, 402. Sur une de ses faces principales 401, peuvent être disposés des composants électroniques identiques ou différents de ceux du substrat hôte. Cette configuration offre la possibilité de réaliser des empilements fonctionnels par intégration 3D.

### Positionnement du cordon de scellement 500 :

Un cordon de scellement 500 peut être positionné sur le substrat 200 (figure 5A), sur la face 201 du substrat qui est recouverte par le composant électronique 300 à encapsuler.

Selon une variante représentée sur la figure 5B, le cordon de scellement 500 est positionné sur la face 401 du capot 400 destinée à faire face au substrat 200, à être en regard du substrat 200 (figure 5B). Si le capot comprend des composants microélectroniques, le cordon sera déposé sur cette même face.

Selon une autre variante non représentée, un cordon 500 pourrait être positionné sur le capot 400 et un autre sur le substrat 200.

Un cordon peut être utilisé pour encapsuler plusieurs batteries. Avantageusement, chaque microbatterie est entourée par un cordon de scellement 500.

Comme représenté sur la figure 5C, les cordons de scellement 500 sont positionnés de telle sorte qu'une fois que le capot 400 sera reporté sur le substrat 200, les cordons 500 entourent les microbatteries 300 à encapsuler pour les isoler de l'atmosphère. Dans le cas de microbatteries 300, comme représenté sur les figures 5A et 5C, le cordon 500 est, avantageusement, disposé au niveau des collecteurs de courant 301, 302 pour gagner de la place et faciliter la miniaturisation.

Le cordon de scellement 500 a une épaisseur qui peut varier de quelques microns à une centaine de microns. Par épaisseur, on entend la dimension perpendiculaire à l'empilement substrat/capot. Son épaisseur sera choisie par l'homme du métier afin de créer, une fois le procédé d'encapsulation achevé, une cavité entre le substrat 200 et le capot d'encapsulation 400 suffisante pour ne pas perturber les cycles de charge et de décharge des microbatteries. Ces cycles, qui correspondent à un phénomène d'insertion/désinsertion du lithium entre les deux électrodes, se traduisent généralement par des phénomènes d'expansion volumique des électrodes. Il est donc primordial de former une cavité suffisamment haute pour un libre mouvement vertical des électrodes. La hauteur d'une telle cavité dépend de la différence de hauteur entre l'épaisseur du cordon 500 et celle de l'empilement des couches actives 310 de la batterie 300. Typiquement, la valeur minimale de cette hauteur est fixée autour de 5% de la valeur de l'épaisseur totale de la microbatterie 300. La largeur et l'épaisseur du cordon de scellement 500 sont optimisées en fonction de la taille des éléments à protéger afin de réduire efficacement l'encombrement de la surface des cordons 500 par rapport à la surface totale du dispositif microbatterie. La largeur du cordon de scellement 500 sera d'au moins 100µm, dans le cas d'un substrat 200 avec des microbatteries 300. De telles dimensions satisfont aux propriétés d'étanchéité et de tenue mécanique requises. On utilisera, par exemple, une épaisseur de 50µm et une largeur de 100µm. L'épaisseur sera réduite lors du chauffage localisé. En fin d'étape d'encapsulation, l'épaisseur sera, avantageusement réduite, jusqu'à une épaisseur de 20 à 25 µm, pour une largeur d'environ 100µm. Par exemple, un cordon de pâte de verre d'une épaisseur de 50µm peut être réduite de 10% à 30% par effet de chauffage thermique selon la nature de la pâte de verre utilisée.

Le cordon de scellement 500 est en un matériau fusible.

Le cordon de scellement 500 peut être métallique, par exemple, pour former des couches métalliques sacrificielles.

De préférence, le cordon est électriquement non conducteur. Il est réalisé, de préférence, à partir d'une pâte de verre. Les pâtes de verre comprennent des particules de verre dispersées dans un liant organique. Par exemple, une pâte de verre peut contenir au moins 70% massique de particules de SiO₂. Le liant organique est détruit en chauffant la pâte de verre. Les pâtes de verre peuvent être vitrifiées à des températures allant de 300°C à 400°C. Les pâtes de verre vitrifiées forment les soudures. Elles maintiennent mécaniquement le capot 400 au substrat 200. Elles sont également étanches vis-à-vis des oxydants de l'air.

A titre d'exemple, les pâtes de verre commercialisées par Namics sous la référence DM2700P/H848, commercialisées par AGC (Asahi Glass Company) sous les références 4290D1, 5115HT1, TNS062-Z27-TP12, 5290D1 ou encore commercialisées par Corning sous la référence Vita™ peuvent être envisagées pour la réalisation du cordon de scellement 500. Ces pâtes de verre sont compatibles avec les matériaux en verre choisis pour le substrat 200 et/ou pour le capot 400 de fermeture et d'encapsulation.

De manière avantageuse, le capot 400, le substrat 200 et le cordon 500 de scellement sont choisis dans la même famille de matériaux, pour avoir des valeurs de CET et/ou module d'Young les plus proches possibles et éviter la création de contraintes mécaniques inhomogènes dans les différents matériaux pouvant conduire à leur fragilisation lors du chauffage laser. De préférence, le capot 400, le substrat 200 et le cordon 500 sont en verre ou à base de verre.

De préférence, le cordon 500 est élaboré à partir de la pâte DM2700P/H848. En plus de ses propriétés intrinsèques barrières vis-à-vis des espèces oxydantes (valeurs de WVTR et de OTR de l'ordre de 10⁻⁶ gm⁻²j⁻¹ et de 10⁻⁶ cm³m⁻²j⁻¹), ce produit possède de bonnes propriétés thermiques (CET de 7,7x10⁻⁶ K⁻¹ à 20°C) très proches des matériaux en verre (CET de 7,2x10⁻⁶ K⁻¹ à 20°C). En outre, ce produit peut être scellé avec des temps relativement courts sous irradiation laser (de l'ordre de 60 secondes), ce qui limite les risques de propagation de chaleur durant l'étape de scellement.

Alternativement, d'autres produits commercialisés par AGC sous la référence 5115HT1 ou par Corning sous la référence Vita™ peuvent être utilisés dans la réalisation du cordon de scellement 500.

Le cordon 500 peut être formé sur le substrat 200 et/ou sur le capot 400 en déposant le matériau fusible localement par toute technique adaptée (par dispense (« dispensing »), par exemple à l'aide d'une seringue calibrée, par sérigraphie ou autres). Le cordon de scellement peut être également obtenu en déposant le matériau fusible puis en le gravant selon le motif souhaité.

Après l'étape de dépôt de la pâte de verre, le cordon de scellement 500 obtenu est, avantageusement, soumis à un traitement thermique (pré-chauffage) pour sécher, évaporer les solvants. La température du traitement est, par exemple, de 100°C à 160°C, par exemple de l'ordre de 150°C. La durée du traitement va, par exemple, de quelques minutes à une heure, par exemple de l'ordre de 30 minutes. Ce traitement thermique permet, avantageusement, de dégazer au moins partiellement les produits volatils présents dans le cordon de scellement. Par exemple, pour une pâte de verre, il peut s'agir de produits organiques (10 à 15% en volume).

De préférence, le cordon de scellement 500 est positionné sur le capot 400 (figure 5B), pour pouvoir effectuer un recuit sans risquer d'altérer les composants microélectroniques du substrat 200 sensibles à la température. Des températures supérieures à 160°C peuvent être utilisées, dans ce mode de réalisation.

### Positionnement du substrat 200 et du capot 400 :

Afin de procéder à l'encapsulation, comme représenté sur la figure 5C, le substrat 200 est disposé sur la zone d'accueil 111 de la cellule de scellement 100 et le capot 400, muni du cordon de scellement 500, repose sur la paroi latérale 120 de la cellule de scellement 100, et, de manière avantageuse, sur le joint 126 de la face supérieure 123. La paroi latérale 120 sert de soutien au capot 400. Les cordons de scellement 500 sont en regard des collecteurs de courants 301, 302 des microbatteries 300. Le positionnement des différents éléments est réalisé de façon à faire entourer les couches actives 310 des microbatteries 300 par les cordons de scellement 500. La position des microbatteries 300 peut être ajustée verticalement et latéralement grâce à une zone d'accueil 111 surélevée.

### Mise sous vide de la cellule de scellement 100 :

La cavité formée par le fond 110 et la paroi latérale 120 de la cellule de scellement 100 ainsi que par le capot 400 est mise sous vide. Le capot 400 joue, en plus de son rôle d'encapsulant final de la microbatterie 300, également le rôle d'un clapet de fermeture de la cellule de scellement 100. Le capot 400 présente une surface supérieure à la surface délimitée par la paroi latérale, de manière à pouvoir fermer la cavité de la cellule de scellement 100.

La mise sous vide est réalisée à travers l'ouverture 130, ou passage. La vanne 131 de l'ouverture 130 est ouverte lors de la mise sous vide.

Par mise sous vide, on entend que la pression est inférieure à la pression atmosphérique (environ 1013,25hPa). Par exemple, la mise sous vide est réalisée en mettant l'enceinte à une pression inférieure à 10⁵ Pa, et de préférence, en mettant l'enceinte à une pression allant de 1kPa à 3kPa.

La mise sous vide de l'enceinte 100 engendre une déformation du capot 400 jusqu'à mettre en contact les cordons de scellement 500 à la fois avec le capot 400 et le substrat 200. Par mise en contact avec le substrat, on entend que le cordon de scellement 500 va toucher le substrat 200 ou l'élément du substrat sur lequel il doit être scellé de manière à fixer le capot 400 au substrat 200 après vitrification du cordon 500. Par exemple, dans le cas des microbatteries 300, le cordon 500 est en contact avec les collecteurs de courant 301, 302 disposés et solidaires du substrat 200). Chaque microbatterie 300 se trouve alors disposée dans des cavités locales délimitées par le capot 400, le substrat 200 et les cordons de scellement 500.

Comme représenté sur la figure 5D, lorsque la cavité est sous vide, le capot 400 est déformé. La déformation résulte de la différence de pression entre l'intérieur de la cavité et l'extérieur de la cavité.

La souplesse du capot 400 est un paramètre essentiel pour optimiser les phénomènes de flambage pendant les opérations de scellement par laser. La trajectoire de la déformation du capot 400 est liée à la nature et à l'épaisseur du matériau du capot 400, mais aussi à la forme géométrique de la cellule de scellement 100 et, plus particulièrement, à celle de la paroi latérale 120 qui le soutient.

Avantageusement, on utilisera une paroi latérale 120 avec un chanfrein 124 (de préférence avec un angle d'inclinaison α, orienté vers l'intérieur de la cellule, inférieur à 90°, et de préférence de l'ordre de 45°) pour faciliter la déformation du capot 400 et ainsi améliorer l'aplatissement du capot 400 au regard des cordons de scellement 500.

La minimisation de la distance H1 entre la première zone d'accueil 111 et le capot 400 permet également de maximiser la force d'appui sur les cordons de scellements 500. On utilisera, avantageusement, une zone d'accueil 111 surélevée par rapport à la zone périphérique 112 du fond 110 de la cellule de scellement 100.

On choisira les différents paramètres de manière à avoir une déformation du capot 400 telle que la surface de contact ente le cordon de scellement 500 et le substrat 200 (ou le capot 400, selon l'élément sur lequel a été déposé le cordon de scellement 500) est supérieure ou égale à 80% de la surface totale du cordon 500.

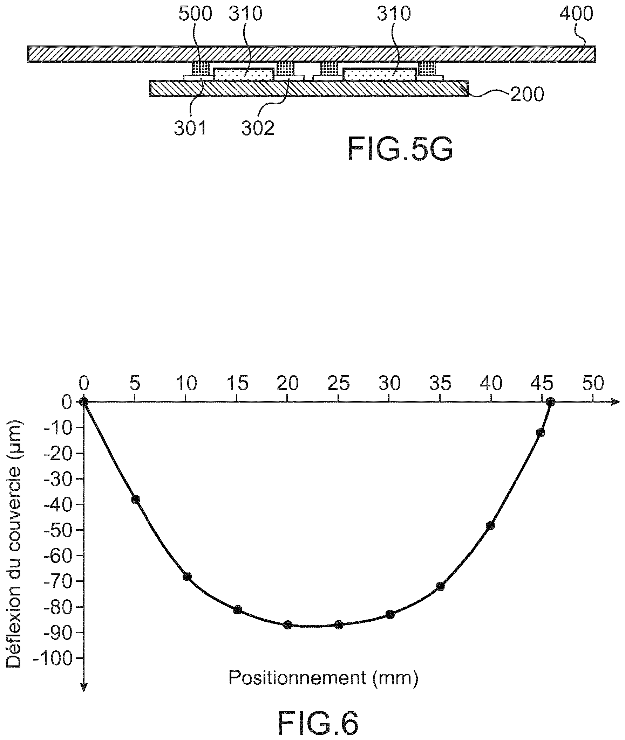

La figure 6 est une représentation graphique de la trajectoire d'un capot 400 en verre D263T soumis à une déformation engendrée par une mise sous vide de l'enceinte entre 1 et 3 kPa. Dans l'exemple, le capot 400 est sur un joint 126 torique en nitrile, d'une dureté de 75 shore A et d'un diamètre de tore de 2,7mm ». Les dimensions de la gorge 125 sont définies par les valeurs D=2,8mm et G=3mm ».

Lorsque la cavité est sous vide, la vanne 131 peut être fermée.

### Scellement du cordon 500 :

Lors de l'étape e), les cordons de scellement 500 sont chauffés, de préférence localement, de manière à être vitrifiés et soudés, pour assurer la cohésion mécanique et l'étanchéité de l'encapsulation. La soudure laser se fait à travers le capot 400.

Avantageusement, les cordons de scellement 500 sont chauffés localement avec un rayonnement laser. Le rayonnement laser est représenté par les flèches L sur la figure 5D. De manière à localiser encore plus le rayonnement laser, on choisira avantageusement une fibre laser.

Le chauffage par irradiation laser est particulièrement avantageux puisqu'il ne nécessite pas de chauffer l'ensemble du substrat 200 et du capot 400. Il permet de chauffer localement les cordons 500 à une température supérieure ou égale à la température de fusion du matériau fusible formant les cordons 500. Par exemple, les cordons 500 sont chauffés localement à plus de 500°C, de préférence au moins à 600°C, par exemple de 600°C à 700°C, de manière à les vitrifier et à former les soudures, nécessaires au scellement. Le capot 400 est ainsi scellé de façon permanente sur le substrat 200 contenant les composants 300.

L'augmentation de la température rend les matériaux des cordons 500 plus aisément déformables par effet de fusion, et augmente la surface de contact entre le cordon 500 et le capot 400 ou le substrat 200. La température peut atteindre, localement, plus de 600°C lors de l'irradiation laser.

Les caractéristiques principales des lasers seront choisies par l'homme du métier en fonction de la nature de la pâte de verre employée pour le cordon 500 et les propriétés optiques du capot 400. Plus particulièrement, la gamme de longueurs d'onde de lasers disponible va de l'infrarouge (lasers CO₂, Nd:YAG, etc.) à la lumière ultraviolette (laser Excimer et des harmoniques de Nd: YAG). Ceci offre la possibilité de choisir la longueur d'onde la plus appropriée pour garantir un collage efficace des pâtes de verre. Par exemple, un rayonnement à une longueur d'onde se situant dans le domaine du proche infrarouge, typiquement à 940 nm, peut être choisi.

Le cordon 500 peut être soumis à une illumination laser pendant une durée allant de quelques dizaines de secondes à quelques centaines de secondes.

Le scellement peut être réalisé pas balayage laser. Le faisceau peut se déplacer à une vitesse de quelques mm/s, par exemple de l'ordre de 2mm/s. Par exemple, une illumination laser à une puissance de 80W pendant 60s, avec un déplacement de 2mm/s est suffisante pour engendrer l'abrasion du cordon 500.

L'attachement du capot 400 au substrat 200 est réalisé, d'une part grâce à la mise sous vide, qui permet d'exercer une pression sur les cordons de scellement 500 avec le capot 400, et d'autre part grâce au chauffage localisé. Une interface de scellement est créée entre les deux surfaces des pièces 200, 400 à assembler.

La compression du capot 400 apporte une assistance mécanique en exerçant une force localisée, au niveau des cordons de scellement 500, pendant le scellement laser. Cette force d'appui permet de plaquer le capot 400 sur les cordons de scellement 500, ce qui augmente la surface de contact entre le cordon 500 et le substrat 200.

Selon une variante, comme représenté sur la figure 5E, la compression peut être assistée par une force mécanique externe à la cellule de scellement 100. Par exemple, un stylet mécanique équipé d'une source laser adéquate (flèche L) et d'une roulette mécanique d'appui 600 peut être utilisé. La roulette mécanique 600 exerce une pression supplémentaire au moment de la fusion du cordon de scellement 500 par irradiation laser.

Selon une autre variante, représentée sur la figure 5F, le stylet mécanique est équipé d'une source laser (flèche L) et d'un moyen de focalisation du faisceau. Avantageusement, la roulette d'appui 600 a à la fois un rôle de lentille de concentration et d'appui mécanique ponctuel.

Contrairement aux procédés de l'art antérieur, les cordons de scellement 500 réalisés selon l'invention sont complètement soudés (il n'y a pas de problèmes liés à la planéité du substrat) et les soudures obtenues sont plus robustes et plus étanches (figure 5G) que celles de l'art antérieur (figure 1).

Le procédé est, avantageusement, réalisé dans un environnement inerte, de manière à remplir les cavités, délimitées par le substrat 200, le capot 400 et le cordon de scellement 500, avec un gaz inerte. Des getters peuvent également être utilisés pour piéger l'oxygène et la vapeur d'eau. Le procédé est, par exemple, réalisé dans une boîte à gants.

Après les différentes étapes du procédé d'encapsulation, la cavité de la cellule de scellement 100 est remise à pression ambiante via l'ouverture 130 et la vanne 131. Le capot 400, qui présente une surface supérieure à celle du substrat 200, peut être découpé. Les différents composants microélectroniques 300, chacun protégé individuellement, peuvent être séparés les uns des autres.

Le procédé de la présente invention permet d'encapsuler de façon groupée simultanée plusieurs composants microélectroniques disposés sur un même substrat ou sur plusieurs substrats et, plus particulièrement, des composants réalisés sur des substrats ultrafins avec des capots ultrafins.

## Revendications

1. Procédé d'encapsulation d'un composant microélectronique (300) disposé sur un substrat (200) comprenant au moins les étapes successives suivantes :
a) fourniture d'une cellule de scellement (100) comportant : un fond (110) avec une zone d'accueil (111) pour le substrat (200) et une zone périphérique (112) entourant la zone d'accueil (111), une paroi latérale (120) formée d'une face interne (121), d'une face externe (122) et d'une face supérieure (123), la face supérieure (123) étant configurée pour supporter le capot (400) en regard de la zone d'accueil (111), une ouverture (130), disposée dans le fond de la cellule (110), dans la paroi latérale (120), ou dans le capot (400), l'ouverture étant configurée pour être reliée à un système de pompage, de manière à pouvoir mettre sous atmosphère contrôlée une cavité délimitée par la paroi latérale (120), le fond (110) et le capot (400),
b) dépôt d'un cordon de scellement (500), sur le substrat (200) et/ou sur la face (401) du capot (400) destinée à être en regard du substrat (200),
c) positionnement du substrat (200) muni du composant microélectronique (300) à encapsuler sur la zone d'accueil (111) de la cellule de scellement (100), et positionnement du capot (400) sur la face supérieure (123) de la cellule de scellement (100), le capot étant à base d'un matériau à base de verre ou de la famille des verres, ou de silicium ou de céramique.
d) mise sous atmosphère contrôlée de la cavité formée par le capot (400) et la cellule de scellement (100), via l'ouverture (130), de manière à faire fléchir le capot (400) vers le substrat (200), jusqu'à mettre en contact le cordon de scellement (500) à la fois avec le substrat (200) et avec le capot (400),
e) chauffage localisé du cordon de scellement (500), de manière à sceller le capot (400) au substrat (200).

2. Procédé selon la revendication 1, le capot (400) étant à base d'un matériau ayant un premier coefficient d'expansion thermique, le substrat (200) étant à base d'un matériau ayant un deuxième coefficient d'expansion thermique qui varie d'au plus 10% par rapport à celui du premier coefficient d'expansion thermique.

3. Procédé selon l'une des revendications 1 ou 2, le capot (400) présentant un module d'Young supérieur à 20 GPa et inférieur ou égal à 100 GPa.

4. Procédé selon l'une des revendications 1 à 3, le cordon de scellement étant un matériau fusible choisi, notamment, parmi une pâte de verre, et un matériau métallique.

5. Procédé selon l'une des revendications 1 à 4, le cordon de scellement étant chauffé par irradiation laser, à travers le capot, le capot (400) étant transparent à la longueur d'onde du laser.

6. Procédé selon l'une des revendications 1 à 5, lors de l'étape d) et/ou de l'étape e), une force mécanique étant exercée sur le capot (400) pour accentuer la flexion du capot (400) vers le substrat (200).

7. Procédé selon la revendication 6, la force mécanique étant réalisée avec un stylet mécanique.

8. Procédé selon la revendication 7, le stylet mécanique étant équipé d'une source laser avec, en particulier, un moyen de focalisation dudit faisceau laser.

9. Procédé selon l'une quelconque des revendications 1 à 8, dans lequel les valeurs des coefficients d'expansion thermique du capot (400), du substrat (200) et du cordon de scellement (500) varient d'au plus 10% entre eux ou dans lequel le capot (400) et/ou le substrat (200) et/ou le cordon de scellement (500) sont en verre.

10. Procédé selon l'une quelconque des revendications 1 à 9, dans lequel un matériau de scellement (500) est disposé à l'étape b) sur la face (401) du capot (400) destinée à être en regard du substrat (200).

11. Dispositif pour encapsuler un microcomposant (300), tel qu'un composant microélectronique (300), disposé sur un substrat (200), comprenant :
- une cellule de scellement (100) comportant un fond (110) ayant une zone d'accueil (111) pour le substrat (200) et une zone périphérique (112) entourant la zone d'accueil (111), une paroi latérale (120) formée d'une face interne (121), d'une face externe (122) et d'une face supérieure (123), ayant un capot (400) positionné sur la face supérieure (123) en regard de la zone d'accueil (111), une ouverture (130), disposée dans le fond de la cellule (110), dans la paroi latérale (120), ou dans le capot (400), l'ouverture étant configurée pour être reliée à un système de pompage, de manière à pouvoir mettre sous atmosphère contrôlée une cavité délimitée par la paroi latérale (120), le fond (110) et le capot (400), de manière à faire fléchir le capot (400) vers la zone d'accueil (111), **caractérisé en ce que** le capot (400) est dans un matériau à base de verre ou de la famille des verres, ou de silicium ou de céramique.

12. Dispositif selon la revendication 11, le capot présentant un module d'Young supérieur à 20 GPa et inférieur ou égal à 100 GPa.

13. Dispositif selon l'une des revendications 11 ou 12, dans lequel la cellule de scellement comprend un chanfrein (124) disposé entre la face supérieure (123) et la face interne (121) de la paroi latérale (120) ou dans lequel la cellule de scellement comprend une zone d'accueil (111) avec un évidement (E), de manière à former un logement pour le substrat (200).

## Patentansprüche

1. Verfahren zum Einkapseln eines mikroelektronischen Bauteils (300), das auf einem Substrat (200) angeordnet ist, umfassend zumindest die nachstehenden, aufeinanderfolgenden Schritte:
a) Bereitstellen einer Abdichtungszelle (100), enthaltend: einen Boden (110) mit einem Aufnahmebereich (111) für das Substrat (200) und einem Umfangsbereich (112), der den Aufnahmebereich (111) umgibt, eine Seitenwand (120), die aus einer Innenfläche (121), einer Außenfläche (122) und einer oberen Fläche (123) gebildet ist, wobei die obere Fläche (123) dazu ausgelegt ist, die dem Aufnahmebereich (111) gegenüberliegende Abdeckung (400) abzustützen, eine Öffnung (130), die im Zellenboden (110), in der Seitenwand (120) oder in der Abdeckung (400) angeordnet ist, wobei die Öffnung dazu ausgelegt ist, an ein Pumpsystem angeschlossen zu werden, so dass ein von der Seitenwand (120), dem Boden (110) und der Abdeckung (400) begrenzter Hohlraum unter eine kontrollierte Atmosphäre gebracht werden kann,
b) Aufbringen eines Dichtungswulstes (500) auf das Substrat (200) und/oder auf die Fläche (401) der Abdeckung (400), die dem Substrat (200) gegenüberliegen soll,
c) Positionieren des mit dem einzukapselnden mikroelektronischen Bauteil (300) versehenen Substrats (200) auf den Aufnahmebereich (111) der Abdichtungszelle (100) und Positionieren der Abdeckung (400) auf die obere Fläche (123) der Abdichtungszelle (100), wobei die Abdeckung auf Basis eines Materials auf Basis von Glas oder der Gruppe der Gläser oder von Silizium oder Keramik besteht,
d) Aussetzen des aus der Abdeckung (400) und der Abdichtungszelle (100) gebildeten Hohlraums einer kontrollierten Atmosphäre mittels der Öffnung (130), so dass die Abdeckung (400) in Richtung auf das Substrat (200) umgebogen wird, bis der Dichtungswulst (500) sowohl mit dem Substrat (200) als auch mit der Abdeckung (400) in Kontakt gebracht wird,
e) bereichsweises Erwärmen des Dichtungswulstes (500), um die Abdeckung (400) mit dem Substrat (200) abdichtend zu verbinden.

2. Verfahren nach Anspruch 1,
wobei die Abdeckung (400) auf Basis eines Materials mit einem ersten Wärmeausdehnungskoeffizienten besteht, während das Substrat (200) auf Basis eines Materials mit einem zweiten Wärmeausdehnungskoeffizienten besteht, der um höchstens 10 % in Bezug auf den ersten Wärmeausdehnungskoeffizienten abweicht.

3. Verfahren nach einem der Ansprüche 1 oder 2,
wobei die Abdeckung (400) einen Elastizitätsmodul von mehr als 20 GPa und weniger als oder gleich 100 GPa aufweist.

4. Verfahren nach einem der Ansprüche 1 bis 3,
wobei der Dichtungswulst aus einem schmelzbaren Material besteht, das insbesondere aus einer Glaspaste und einem metallischen Werkstoff ausgewählt ist.

5. Verfahren nach einem der Ansprüche 1 bis 4,
wobei der Dichtungswulst durch Laserbestrahlung durch die Abdeckung hindurch erwärmt wird, wobei die Abdeckung (400) für die Wellenlänge des Lasers transparent ist.

6. Verfahren nach einem der Ansprüche 1 bis 5,
wobei in Schritt d) und/oder Schritt e) eine mechanische Kraft auf die Abdeckung (400) ausgeübt wird, um die Biegung der Abdeckung (400) in Richtung auf das Substrat (200) zu verstärken.

7. Verfahren nach Anspruch 6,
wobei die mechanische Kraft mit einem mechanischen Stift aufgebracht wird.

8. Verfahren nach Anspruch 7,
wobei der mechanische Stift mit einer Laserquelle, insbesondere mit einem Mittel zur Fokussierung des Laserstrahls, ausgestattet ist.

9. Verfahren nach einem der Ansprüche 1 bis 8,
wobei die Werte der Wärmeausdehnungskoeffizienten der Abdeckung (400), des Substrats (200) und des Dichtungswulstes (500) um höchstens 10% voneinander abweichen oder wobei die Abdeckung (400) und/oder das Substrat (200) und/oder der Dichtungswulst (500) aus Glas bestehen.

10. Verfahren nach einem der Ansprüche 1 bis 9,
wobei in Schritt b) ein Dichtungsmaterial (500) auf diejenige Fläche (401) der Abdeckung (400), die dem Substrat (200) gegenüberliegen soll, angeordnet wird.

11. Vorrichtung zum Einkapseln eines Mikrobauteils (300), wie etwa eines mikroelektronischen Bauteils (300), das auf einem Substrat (200) angeordnet ist, enthaltend:
- eine Abdichtungszelle (100) mit einem Boden (110), der einen Aufnahmebereich (111) für das Substrat (200) und einen den Aufnahmebereich (111) umgebenden Umfangsbereich (112) aufweist, einer Seitenwand (120), die aus einer Innenfläche (121), einer Außenfläche (122) und einer oberen Fläche (123) gebildet ist, die eine auf die obere Fläche (123) dem Aufnahmebereich (111) gegenüberliegend positionierte Abdeckung (400) aufweist, einer Öffnung (130), die im Zellenboden (110), in der Seitenwand (120) oder in der Abdeckung (400) angeordnet ist, wobei die Öffnung dazu ausgelegt ist, an ein Pumpsystem angeschlossen zu werden, so dass ein von der Seitenwand (120), dem Boden (110) und der Abdeckung (400) begrenzter Hohlraum einer kontrollierten Atmosphäre ausgesetzt werden kann,
**dadurch gekennzeichnet, dass** die Abdeckung (400) aus einem Material auf Basis von Glas oder der Gruppe der Gläser oder von Silizium oder Keramik besteht.

12. Vorrichtung nach Anspruch 11,
wobei die Abdeckung einen Elastizitätsmodul von mehr als 20 GPa und weniger als oder gleich 100 GPa aufweist.

13. Vorrichtung nach einem der Ansprüche 11 oder 12,
wobei die Abdichtungszelle eine Abschrägung (124) aufweist, die zwischen der oberen Fläche (123) und der Innenfläche (121) der Seitenwand (120) angeordnet ist, oder wobei die Abdichtungszelle einen Aufnahmebereich (111) mit einer Ausnehmung (E) aufweist, so dass eine Aufnahme für das Substrat (200) gebildet wird.

## Claims

1. Method for encapsulating a microelectronic component (300) arranged on a substrate (200) comprising at least the following successive steps:
a) supplying a sealing cell (100) including: a bottom (110) with a receiving zone (111) for the substrate (200) and a peripheral zone (112) surrounding the receiving zone (111), a side wall (120) formed by an internal face (121), an external face (122) and an upper face (123), the upper face (123) being configured to support the cap (400) facing the receiving zone (111), an opening (130), arranged in the bottom of the cell (110), in the side wall (120), or in the cap (400), the opening being configured to be connected to a pumping system, in such a way as to be able to place under controlled atmosphere a cavity delimited by the side wall (120), the bottom (110) and the cap (400),
b) depositing a sealing bead (500), on the substrate (200) and/or on the face (401) of the cap (400) intended to be facing the substrate (200),
c) positioning the substrate (200) provided with the microelectronic component (300) to encapsulate the receiving zone (111) of the sealing cell (100), and positioning the cap (400) on the upper face (123) of the sealing cell (100), the cap being based on a material based on glass or the family of glasses, or silicon or ceramic,
d) placing under controlled atmosphere the cavity formed by the cap (400) and the sealing cell (100), via the opening (130), in such a way as to make the cap (400) bend towards the substrate (200), until the sealing bead (500) is placed in contact both with the substrate (200) and with the cap (400),
e) localised heating of the sealing bead (500), in such a way as to seal the cap (400) to the substrate (200).

2. Method according to claim 1, the cap (400) being based on a material having a first thermal expansion coefficient, the substrate (200) being based on a material having a second thermal expansion coefficient which varies by at most 10% compared to that of the first thermal expansion coefficient.

3. Method according to any of claims 1 or 2, the cap (400) having a Young's modulus greater than 20 GPa and less than or equal to 100 GPa

4. Method according to any of claims 1 to 3, the sealing bead being a fusible material selected in particular from a glass paste and a metal material.

5. Method according to any of claims 1 to 4, the sealing bead being heated by laser irradiation, through the cap, the cap (400) being transparent to the laser wavelength.

6. Method according to any of claims 1 to 5, during step d) and/or step e), a mechanical force being exerted on the cap (400) to accentuate the bending of the cap (400) towards the substrate (200).

7. Method according to claim 6, the mechanical force being produced by a mechanical stylus.

8. Method according to claim 7, the mechanical stylus being equipped with a laser source having in particular a mean for focusing said laser beam.

9. Method according to any of claims 1 to 8, wherein the values of the thermal expansion coefficients of the cap (400), the substrate (200) and the sealing bead (500) vary by at most 10% from each other or wherein the cap (400) and/or the substrate (200) and/or the sealing bead (500) are made of glass.

10. Method according to any of claims 1 to 9, wherein a sealing material (500) is arranged in step b) on the face (401) of the cap (400) intended to be facing the substrate (200).

11. Device for encapsulating a microcomponent (300) such as a microelectronic component (300), arranged on a substrate (200), including:
- a sealing cell (100) comprising a bottom (110) having a receiving zone (111) for the substrate (200) and a peripheral zone (112) surrounding the receiving zone (111), a side wall (120) formed by an internal face (121), an external face (122) and an upper face (123), having a cap (400) positioned on the upper face (123), facing the receiving zone (111), an opening (130) arranged in the bottom of the cell (110) in the side wall (120), or in the cap (400), the opening being configured to be connected to a pumping system, in such a way as to be able to place under controlled atmosphere a cavity delimited by the side wall (120), the bottom (110) and the cap (400), in such a way as to bend the cap (400) towards the receiving zone (111),
**characterised in that** the cap (400) is made from a material based on glass or the family of glasses, or silicon or ceramic.

12. Device according to claim 11, the cap having a Young's modulus greater than 20 GPa and less than or equal to 100 GPa.

13. Device according to any of claims 11 or 12, wherein the sealing cell comprises a bevelled edge (124) arranged between the upper face (123) and the internal face (121) of the side wall (120) or wherein the sealing cell comprises a receiving zone (111) with a cavity (E), in such a way as to form a housing for the substrate (200).
